# EUROPEAN PATENT APPLICATION

(11) **EP 2 226 861 A2**
(43) Date of publication of application: **08.09.2010**
(21) Application number: 10155283.4
(22) Date of filing: 03.03.2010
(51) Int. Cl.: H01L 33/52

(54) **Light emitting diode package structure and manufacturing method thereof**

(30) Priority: 03.03.2009 TW 98106884
(71) Applicant: Everlight Electronics Co., Ltd., Tucheng City / Taipei County (TW)
(72) Inventor: Hsin, Chia-Fen, Taipei (TW)
(74) Representative: Chamberlain, Alan James

(57) **Abstract**

A manufacturing method of a light emitting diode package structure (200) is disclosed. First, a carrier (210) and an LED chip (220) are provided, wherein the LED chip is disposed on the carrier and located in a cavity. Next, a first molding compound (230) is filled into the cavity, wherein the first molding compound overlays the LED chip and the first molding compound is mixed up with a fluorescent material (232). Then, a first baking process to make the first molding compound in semi-cured state is conducted. After that, a second molding compound (240) is filled into the cavity, wherein the second molding compound overlays the first molding compound.

## Description

### BACKGROUND OF THE INVENTION

### 1. Field of the Invention

The present invention generally relates to a semiconductor package structure and a manufacturing method thereof, and more particularly, to a light emitting diode (LED) package structure and a manufacturing method.

### 2. Description of Related Art

LEDs have many advantages, such as long lifetime, small volume, high shock absorption, low heat and power saving, so that LEDs have widely used in various indicators or light sources for home appliances and other equipments. In recent years, the LED applications have been developed towards multi colors and high luminance and thereby expanded to mega-size display board, traffic light and the related fields. In future, LEDs can be expected to play the major role for illumination light sources featuring power saving and environmental protection.

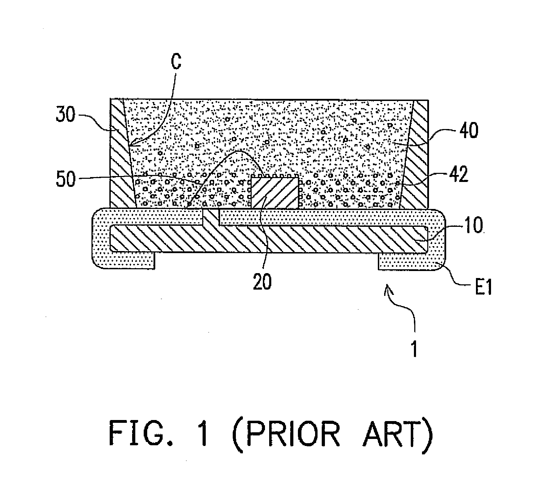

Fig. 1 is a diagram of a conventional surface mount device (SMD) LED package structure. Referring to Fig. 1, a SMD LED package structure 1' includes a carrier 10, an LED chip 20, a casing 30 and a molding compound 40. The LED chip 20 is disposed on the carrier 10 and located in a cavity C formed by the carrier 10 and the casing 30, wherein the LED chip 20 is electrically connected to the carrier 10 through a bounding wire 50. The molding compound 40 has a mixed up fluorescent material 42 and the cavity C is filled with the molding compound 40 to encapsulate the LED chip 20 and the bounding wire 50. The partial carrier 10 exposed out of the molding compound 40 serves as an external electrode E1 electrically connected between the LED package structure 1' and an external terminal.

The conventional LED package structure 1' is manufactured in mass production, where each cavity C is filled with the molding compound 40, followed by conducting a baking process to cure the molding compound 40 at the same time so as to complete the LED package structure 1'. However, during the waiting time for the baking process (about one day long prior to the baking), the fluorescent material 42 mixed in the molding compound 40 would be distributed ununiformly (that is, the most fluorescent material 42 are sedimentated on the bottom surface of the cavity C or on the surface of the chip) since the sedimentating after filing the molding compound is for too long time or due to different starting time of filling process. As a result, only a small amount of the fluorescent material 42 is scattered and distributed in the molding compound 40, which affects the light-emitting uniformity of the produced LED package structure.

### SUMMARY OF THE INVENTION

Accordingly, the present invention is directed to an LED package structure and a manufacturing method thereof for reducing the problem of the ununiformly distributing of the fluorescent material in the molding compound so as to increase the light-emitting uniformity of the LED package structure.

The present invention provides a manufacturing method of a light emitting diode package structure. First, a carrier and an LED chip are provided, wherein the LED chip is disposed on the carrier and located in a cavity. Next, a first molding compound is filled into the cavity, wherein the first molding compound overlays the LED chip and the first molding compound is mixed up with a fluorescent material. Then, a first baking process to make the first molding compound in semi-cured state is conducted. After that, a second molding compound is filled into the cavity, wherein the second molding compound overlays the first molding compound.

In an embodiment of the present invention, the above-mentioned carrier includes a circuit board or a lead frame.

In an embodiment of the present invention, the material of the above-mentioned first molding compound includes methyl-series silicone adhesive or ethylic-series silicone adhesive.

In an embodiment of the present invention, the above-mentioned baking process is to make the temperature of the first molding compound in semi-cured state ranged between 80°C and 90°C and takes baking time between 5 minutes and 10 minutes.

In an embodiment of the present invention, the material of the above-mentioned first molding compound includes cyclobenzene-series silicone adhesive.

In an embodiment of the present invention, the above-mentioned baking process is to make the temperature of the first molding compound in semi-cured state ranged between 80°C and 100°C and takes baking time between 20 minutes and 30 minutes.

In an embodiment of the present invention, the above-mentioned manufacturing method of an LED package structure further includes conducting a second baking process to cure the first molding compound and the second molding compound.

In an embodiment of the present invention, the material of the above-mentioned second molding compound includes methyl-series silicone adhesive, ethylic-series silicone adhesive or cyclobenzene-series silicone adhesive.

In an embodiment of the present invention, the above-mentioned LED chip includes blue LED chip, red LED chip, green LED chip or ultraviolet light LED chip.

In an embodiment of the present invention, the above-mentioned fluorescent material includes yellow fluorescent powder, red fluorescent powder, green fluorescent powder, blue fluorescent powder or yttrium aluminum garnet fluorescent powder (YAG fluorescent powder).

In an embodiment of the present invention, prior to filling the first molding compound into the cavity, the above-mentioned method further includes forming at least an electrical path so that the LED chip is electrically connected to the carrier through the electrical path.

The present invention also provides an LED package structure, which includes a carrier, an LED chip, a first molding compound and a second molding compound. The carrier has a cavity. The LED chip is disposed on the carrier and accommodated in the cavity. The first molding compound is disposed in the cavity and overlays the LED chip, wherein the first molding compound is mixed up with a fluorescent material. The second molding compound is disposed in the cavity and overlays the first molding compound.

In an embodiment of the present invention, the above-mentioned LED package structure further includes a casing disposed on the carrier and overlaying a part of the carrier, wherein the casing and the carrier together form the cavity.

In an embodiment of the present invention, the above-mentioned carrier includes a circuit board.

In an embodiment of the present invention, the above-mentioned LED chip includes blue LED chip, red LED chip, green LED chip or ultraviolet light LED chip.

In an embodiment of the present invention, the above-mentioned fluorescent material includes yellow fluorescent powder, red fluorescent powder, green fluorescent powder, blue fluorescent powder or yttrium aluminum garnet fluorescent powder (YAG fluorescent powder).

In an embodiment of the present invention, the material of the above-mentioned first molding compound includes methyl-series silicone adhesive, ethylic-series silicone adhesive or cyclobenzene-series silicone adhesive.

In an embodiment of the present invention, the material of the above-mentioned second molding compound includes methyl-series silicone adhesive, ethylic-series silicone adhesive or cyclobenzene-series silicone adhesive.

In an embodiment of the present invention, the above-mentioned LED package structure further includes at least an electrical path so that the LED chip is electrically connected to the carrier through the electrical path.

The present invention further provides an LED package structure, which includes a carrier, an LED chip, a first molding compound, a second molding compound and a package casing. The carrier has a cavity, a first pin and a second pin. The LED chip is disposed on the carrier and located in the cavity. The first molding compound is disposed in the cavity and overlays the LED chip, wherein the first molding compound is mixed up with a fluorescent material. The second molding compound is disposed in the cavity and overlays the first molding compound. The package casing encloses the carrier and exposes the first pin and the second pin.

In an embodiment of the present invention, the above-mentioned carrier includes a lead frame.

In an embodiment of the present invention, the above-mentioned LED chip includes blue LED chip, red LED chip, green LED chip or ultraviolet light LED chip.

In an embodiment of the present invention, the above-mentioned fluorescent material includes yellow fluorescent powder, red fluorescent powder, green fluorescent powder, blue fluorescent powder or yttrium aluminum garnet fluorescent powder (YAG fluorescent powder).

In an embodiment of the present invention, the material of the above-mentioned first molding compound includes methyl-series silicone adhesive, ethylic-series silicone adhesive or cyclobenzene-series silicone adhesive.

In an embodiment of the present invention, the material of the above-mentioned second molding compound includes methyl-series silicone adhesive, ethylic-series silicone adhesive or cyclobenzene-series silicone adhesive.

In an embodiment of the present invention, the above-mentioned LED package structure further includes at least an electrical path so that the LED chip is electrically connected to the carrier through the electrical path.

Since the present invention takes two filling adhesive processes and adds baking steps in the two filling adhesive processes, so that the fluorescent material filled in the first molding compound is unlikely sedimentated on the bottom surface of the cavity or the surface of the chip and evenly distributed in the first molding compound. As a result, when the light emitted from the LED chip passes through the first molding compound and the second molding compound to outside, the LED package structure has better light-emitting uniformity.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

Fig. 1 is a diagram of a conventional surface mount device (SMD) LED package structure.

Fig. 2 is a cross-sectional diagram of an LED package structure according to an embodiment of the present invention.

Fig. 3 is a cross-sectional diagram of an LED package structure according to another embodiment of the present invention.

Figs. 4A-4C are flowchart diagrams showing a manufacturing method for an LED package structure according to an embodiment of the present invention.

### DESCRIPTION OF THE EMBODIMENTS

Reference will now be made in detail to the present preferred embodiments of the invention, examples of which are illustrated in the accompanying drawings. Wherever possible, the same reference numbers are used in the drawings and the description to refer to the same or like parts.

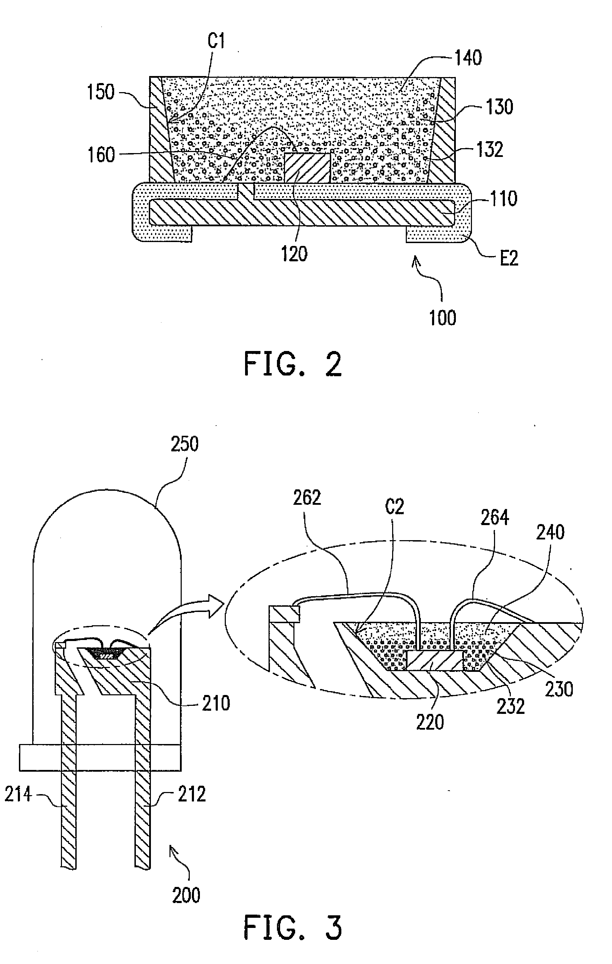

Fig. 2 is a cross-sectional diagram of an LED package structure according to an embodiment of the present invention. Referring to Fig. 2, an LED package structure 100 includes a carrier 110, an LED chip 120, a first molding compound 130, a second molding compound 140 and a casing 150. The LED package structure 100 of the embodiment is an SMD LED package structure 100.

In more details, the casing 150 is disposed on the carrier 110 and overlays a part of the carrier 110, wherein the casing 150 and the carrier 110 together form a cavity C1. The LED chip 120 is disposed on the carrier 110 and accommodated in the cavity C1 to emit light, wherein the LED chip 120 is electrically connected to the carrier 110 through at least an electrical path 160, such as a bounding wire (in Fig. 2, only a bounding wire is illustrated). In the embodiment, the carrier 110 is, for example, a circuit board. The LED chip 120 includes blue LED chip, red LED chip, green LED chip or ultraviolet LED chip.

The first molding compound 130 is disposed in the cavity C1 and overlays the LED chip 120 and a part of the electrical path 160. The first molding compound 130 is mixed up with a fluorescent material 132, wherein the fluorescent material 132 is evenly distributed in the first molding compound 130. In the embodiment, the material of the first molding compound 130 includes methyl-series silicone adhesive, ethylic-series silicone adhesive or cyclobenzene-series silicone adhesive, and the fluorescent material 132 includes yellow fluorescent powder, red fluorescent powder, green fluorescent powder, blue fluorescent powder or yttrium aluminum garnet fluorescent powder (YAG fluorescent powder).

The second molding compound 140 is disposed in the cavity C1 and overlays the first molding compound 130, wherein the first molding compound 130 and the second molding compound 140 protect the LED chip 120 and the electrical path 160 from the influences of external temperature, moisture and noise. In the embodiment, the material of the second molding compound 140 includes methyl-series silicone adhesive, ethylic-series silicone adhesive or cyclobenzene-series silicone adhesive.

It should be noted that white light is blended light with multi colors, while the white light seen by human's eyes is the one formed by two or more than two color light wavelengths, for example, the white light formed by two wavelengths of the blended blue light and yellow light or the white light formed by three wavelengths of the blended red light, green light and blue light. Therefore, when the LED package structure 100 of the embodiment is a white-light LED package structure, the LED chip 120 should be a blue-light LED package structure in association with the first molding compound 130, wherein the fluorescent material 132 in the first molding compound 130 is yellow fluorescent powder. The blue light wavelengths emitted from the blue LED chip are between 440nm and 490nm, and the yellow fluorescent powder after irradiation by the blue light can emit yellow fluorescence. In this way, when the yellow fluorescent powder is blended with the original blue light, so-called white light with two wavelengths can be obtained.

Certainly, the LED chip 120 can be a ultraviolet light LED chip and the associated fluorescent material 132 is red fluorescent powder, green fluorescent powder and blue fluorescent powder, wherein the wavelengths of the ultraviolet light are between 380nm and 450nm. When the red fluorescent powder, green fluorescent powder and blue fluorescent powder are respectively irradiated by the ultraviolet light, they can respectively emit red light, green light and blue light. After blending the red light with the green light and the blue light, so-called white light with three wavelengths is obtained.

It should be noted that, in the embodiment, the casing 150 and the carrier 110 are an integrated formed structure; but in other embodiments, the casing 150 and the carrier 110 can be formed in other ways. In addition, the partial carrier 110 exposed out of the first molding compound 130 and the second molding compound 140 serves as an external electrode E2, through which the LED package structure 100 is electrically connected to outside.

In short, the color light emitted from the LED chip 120 would be delivered to outside sequentially through the first molding compound 130 and the second molding compound 140. During the course, the color light emitted from the LED chip 120 strikes the fluorescent material 132 to excite the fluorescent material 132 to emit color light, so that the emitted color light is blended with another color light emitted from the LED chip 120. Since the fluorescent material 132 in the embodiment is evenly distributed in the first molding compound 130, after the color light emitted from the fluorescent material 132 is blended with the color light emitted from the LED chip 120, the resulting light has better color light uniformity. In other words, when the above-mentioned blended color light is delivered to outside through the second molding compound 140, the LED package structure 100 exhibits better color light uniformity, or the LED package structure 100 of the embodiment has better light-emitting uniformity.

Fig. 3 is a cross-sectional diagram of an LED package structure according to another embodiment of the present invention. Referring to Fig. 3, in the embodiment, the LED package structure 200 includes a carrier 210, a LED chip 220, a first molding compound 230, a second molding compound 240 and a package casing 250. In the embodiment, the LED package structure 200 is a pin through hole (PTH) LED package structure.

In more details, the carrier 210 has a cavity C2, a first pin 212 and a second pin 214. The LED chip 220 is disposed on the carrier 210 and located in the cavity C2, wherein the LED chip 220 is electrically connected to the carrier 210 through two electrical paths 262 and 264. In the embodiment, the carrier 210 includes a lead frame. The LED chip 220 includes blue LED chip, red LED chip, green LED chip or ultraviolet LED chip.

The first molding compound 230 is disposed in the cavity C2 and overlays the LED chip 220 and a part of the electrical paths262 and 264. The first molding compound 230 is mixed up with a fluorescent material 232, wherein the fluorescent material 232 is evenly distributed in the first molding compound 230. In the embodiment, the material of the first molding compound 230 includes methyl-series silicone adhesive, ethylic-series silicone adhesive or cyclobenzene-series silicone adhesive, and the fluorescent material 232 includes yellow fluorescent powder, red fluorescent powder, green fluorescent powder, blue fluorescent powder or yttrium aluminum garnet fluorescent powder (YAG fluorescent powder).

The second molding compound 240 is disposed in the cavity C2 and overlays the first molding compound 230, wherein the first molding compound 230 and the second molding compound 240 protect the LED chip 220 from the influences of external temperature, moisture and noise. In the embodiment, the material of the second molding compound 240 includes methyl-series silicone adhesive, ethylic-series silicone adhesive or cyclobenzene-series silicone adhesive.

The package casing 250 encloses the carrier 210 and exposes the first pin 212 and the second pin 214, wherein the package casing 250 is for protecting the carrier 210 and the LED chip 220 and electrical paths 262 and 264 located on the carrier 210 from the influences of external temperature, moisture and noise. In the embodiment, the material of the package casing 250 is, for example, a light-transmitting material.

It should be noted that white light is blended light with multi colors, while the white light seen by human's eyes is the one formed by two or more than two color light wavelengths, for example, the white light formed by two wavelengths of the blended blue light and yellow light or the white light formed by three wavelengths of the blended red light, green light and blue light. Therefore, when the LED package structure 200 of the embodiment is a white-light LED package structure, the LED chip 220 should be a blue-light LED package structure in association with the first molding compound 230, wherein the fluorescent material 232 in the first molding compound 230 is yellow fluorescent powder. The blue light wavelengths emitted from the blue LED chip are between 440nm and 490nm, and the yellow fluorescent powder after irradiation by the blue light can emit yellow fluorescence. In this way, when the yellow fluorescent powder is blended with the original blue light, so-called white light with two wavelengths can be obtained.

Certainly, the LED chip 220 can be a ultraviolet light LED chip and the associated fluorescent material 232 is red fluorescent powder, green fluorescent powder and blue fluorescent powder, wherein the wavelengths of the ultraviolet light are between 380nm and 450nm. When the red fluorescent powder, green fluorescent powder and blue fluorescent powder are respectively irradiated by the ultraviolet light, they can respectively emit red light, green light and blue light. After blending the red light with the green light and the blue light, so-called white light with three wavelengths is obtained.

In short, the color light emitted from the LED chip 220 would be delivered to outside sequentially through the first molding compound 230, the second molding compound 240 and the package casing 250. During the course, the color light emitted from the LED chip 220 strikes the fluorescent material 232 to excite the fluorescent material 232 to emit color light, so that the emitted color light is blended with another color light emitted from the LED chip 220. Since the fluorescent material 232 in the embodiment is evenly distributed in the first molding compound 230, after the color light emitted from the fluorescent material 232 is blended with the color light emitted from the LED chip 220, the resulting light has better color light uniformity. In other words, when the above-mentioned blended color light is delivered to outside through the second molding compound 240 and the package casing 250, the LED package structure 200 exhibits better color light uniformity, or the LED package structure 200 of the embodiment has better light-emitting uniformity.

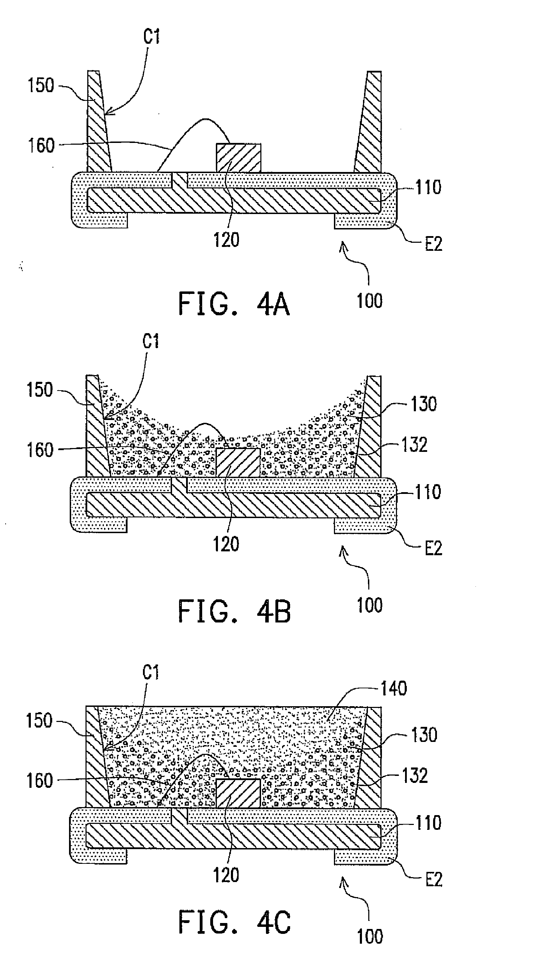

The LED package structures 100 and 200 of the present invention are depicted as described above. In the following, the manufacturing method of a light emitting diode package structure in the present invention is further depicted. The method is depicted against the LED package structure 100 of Fig. 2 in association with Figs. 4A-4C.

Figs. 4A-4C are flowchart diagrams showing a manufacturing method for an LED package structure according to an embodiment of the present invention. In the method, first, a carrier 110 and a LED chip 120 are provided.

In more details, the LED chip 120 is disposed on the carrier 110 and located in a cavity C1, wherein the LED chip 120 is electrically connected to the carrier 110 through at least an electrical path 160, such as bounding wire(in Fig. 4A, only one wire is shown). In the embodiment, the carrier 110 includes a circuit board or a lead frame (not shown). The LED chip 120 includes blue LED chip, red LED chip, green LED chip or ultraviolet LED chip.

Next referring to Fig. 4B, a first molding compound 130 is filled into the cavity C1, wherein the first molding compound 130 overlays the LED chip 120 and the first molding compound 130 is mixed up with a fluorescent material 132. In the embodiment, the material of the first molding compound 130 includes methyl-series silicone adhesive, ethylic-series silicone adhesive or cyclobenzene-series silicone adhesive, and the fluorescent material 132 includes yelow fluorescent powder, red fluorescent powder, green fluorescent powder, blue fluorescent powder or yttrium aluminum garnet fluorescent powder (YAG fluorescent powder).

Then, a first baking process is conducted to make the first molding compound 130 in semi-cured state. In more details, the first baking process of the embodiment is a low-temperature and quick-baking process, wherein the baking time and the baking temperature are related to the material selected by the first molding compound 130. For example, when the material of the first molding compound 130 is methyl-series silicone adhesive or ethylic-series silicone adhesive, the baking process is designed to make the temperature of the first molding compound 130 in semi-cured state ranged between 80°C and 90°C and have baking time between 5 minutes and 10 minutes. When the material of the first molding compound 130 is cyclobenzene-series silicone adhesive, the baking process is designed to make the temperature of the first molding compound 130 in semi-cured state ranged between 80°C and 100°C and have baking time between 20 minutes and 30 minutes.

After that referring to Fig. 4C, a second molding compound 140 is filled into the chip accommodation space C1, wherein the second molding compound 140 overlays the first molding compound 130. The first molding compound 130 and the second molding compound 140 protect the LED chip 120 and the electrical path 160 from the influences of external temperature, moisture and noise. In the embodiment, the second molding compound 140 is adhesive with high transmitting and the material thereof includes methyl-series silicone adhesive, ethylic-series silicone adhesive or cyclobenzene-series silicone adhesive. In another unshown embodiment, the second molding compound 140 is mixed up with a fluorescent material, and after filling the second molding compound 140 into the cavity C1, a baking process (low-temperature and quick-baking process) is conducted, so that the fluorescent material is not sedimentated to promote the light-emitting uniformity.

In more details, in the embodiment, after filling the first molding compound 130 into the cavity C1, a first baking process is immediately conducted to make the first molding compound 130 in semi-cured state. Therefore, when filling the second molding compound 140 into the cavity C1 to overlay the first molding compound 130, there is good adhesiveness between the first molding compound 130 in semi-cured state and the second molding compound 140. In the process, the refractive index of the first molding compound 130 is, for example, 1.5, which is able to promote the light-emitting efficiency of the LED package structure 100 after the color light emitted from the LED package structure 100 is blended with the color light emitted from the fluorescent material 132. The refractive index of the second molding compound 140 is, for example, 1.4, which is able to increase the wearability of the LED package structure 100. At the time, the LED package structure 100 is completed by using the packaging method of a light emitting diode package structure.

It should be noted that, in the embodiment, the casing 150 and the carrier 110 are an integrated formed structure; but in other embodiments, the casing 150 and the carrier 110 can be formed in other ways. In addition, the carrier 110 exposed out of the first molding compound 130 and the second molding compound 140 serves as an external electrode E2, through which the LED package structure 100 is electrically connected to outside. After finishing the first baking process, a second baking process can be simultaneously conducted on the first molding compound 130 and the second molding compound 140. The second baking process is substantially a light curing process, where, for example, ultraviolet light is used to irradiate the first molding compound 130 in semi-cured state and the second molding compound 140 (the material thereof can be light curing adhesive) so as to produce a photo chemistry reaction to completely cure the compounds 130 and 140.

Since the present invention takes two filling adhesive processes and adds the first baking step in the two filling adhesive processes, so that the first molding compound filled in the cavity C1 is in semi-cured state and the fluorescent material 132 in the first molding compound 130 is unlikely sedimentated on the bottom surface of the cavity C1 and evenly distributed in the first molding compound, which benefits increasing the stability of the process. As a result, when the light emitted from the LED chip 120 strikes the fluorescent material 132 to excite the fluorescent material 132 emitting the color light, the color light is blended with the color light emitted from the LED chip 120, which passes through the second molding compound to outside, the LED package structure 100 has better color light uniformity. In other words, the LED package structure 100 manufactured by the above-mentioned method of a light emitting diode package structure of the embodiment has better light-emitting uniformity.

In summary, since the present invention takes two filling adhesive processes and adds baking steps in the two filling adhesive processes to make the filled first molding compound in semi-cured state, so that the fluorescent material filled in the first molding compound is unlikely sedimentated on the bottom surface of the cavity and evenly distributed in the first molding compound, which benefits increasing the stability of the process. In addition, there is good adhesiveness between the first molding compound in semi-cured state and the second molding compound. As a result, when the light emitted from the LED chip passes through the first molding compound and the second molding compound to outside, the LED package structure of the present invention has better light-emitting uniformity.

It will be apparent to those skilled in the art that various modifications and variations can be made to the structure of the present invention without departing from the scope or spirit of the invention. In view of the foregoing, it is intended that the present invention covers modifications and variations of this invention provided they fall within the scope of the following claims and their equivalents.

## Claims

1. A manufacturing method of a light emitting diode package structure (100, 200), comprising:
providing a carrier (110, 210) and a light emitting diode chip (120, 220), wherein the light emitting diode chip (120,220) is disposed on the carrier (110,210);
providing a first molding compound (130,230)on the light emitting diode chip (120, 220), wherein the first molding compound (130, 230) is mixed up with a fluorescent material (132, 232);
performing a first baking process to make the first molding compound (130, 230) in semi-cured state; and
providing a second molding compound (140, 240) on the first molding compound (130,230) .

2. The manufacturing method of a light emitting diode package structure (100, 200)as claimed in claim 1, wherein the material of the first molding compound (130, 230) comprises methyl-series silicone adhesive or ethylic-series silicone adhesive.

3. The manufacturing method of a light emitting diode package structure (100, 200) as claimed in claim 2, wherein the first baking process is performed to make the temperature of the first molding compound (130, 230) in semi-cured state ranged between 80 and 90 and takes baking time between 5 minutes and 10 minutes.

4. The manufacturing method of a light emitting diode package structure (100, 200) as claimed in claim 1, wherein the material of the first molding compound (130, 230) comprises cyclobenzene-series silicone adhesive.

5. The manufacturing method of a light emitting diode package structure (100, 200) as claimed in claim 4, wherein the first baking process is to make the temperature of the first molding compound (130, 230) in semi-cured state ranged between 80 and 100 and takes baking time between 20 minutes and 30 minutes.

6. The manufacturing method of a light emitting diode package structure (100, 200) as claimed in claim 1, further comprising conducting a second baking process to cure the first molding compound (130, 230) and the second molding compound (140,240) .

7. The manufacturing method of a light emitting diode package structure (100, 200) as claimed in claim 1, wherein the material of the second molding compound (140, 240) comprises methyl-series silicone adhesive, ethylic-series silicone adhesive or cyclobenzene-series silicone adhesive.

8. The manufacturing method of a light emitting diode package structure (100, 200) as claimed in claim 1, wherein prior to providing the first molding compound (130, 230) on the light emitting diode chip (120, 220), the method further comprises forming at least an electrical path (160, 262, 264) between the light emitting diode chip (120,220) and the carrier (110, 210) so that the light emitting diode chip (120, 220) is electrically connected to the carrier (110, 210) through the electrical path (160, 262, 264).

9. A light emitting diode package structure (100), comprising:
a carrier (110);
a light emitting diode chip (120) disposed on the carrier (110);
a first molding compound (130) overlaying the light emitting diode chip(120), wherein the first molding compound (130) is mixed up with a fluorescent material (132); and
a second molding compound (140) overlaying the first molding compound (130).

10. The light emitting diode package structure (100) as claimed in claim 9, wherein the carrier (110) has a cavity (C1), the light emitting diode chip (120) is accommodated in the cavity (C1).

11. The light emitting diode package structure (100) as claimed in claim 10, further comprising a casing (150) disposed on the carrier (110) and overlaying a part of the carrier (110), wherein the casing (150) and the carrier (110) together to form the cavity (C1).

12. The light emitting diode package structure (100) as claimed in claim 9, wherein the materials of the first molding compound (130) and the second molding compound (140) comprise methyl-series silicone adhesive, ethylic-series silicone adhesive or cyclobenzene-series silicone adhesive.

13. The light emitting diode package structure (100) as claimed in claim 9, further comprising at least an electrical path (160)located between the light emitting diode chip (120) and the carrier (110) so that the light emitting diode chip (120)is electrically connected to the carrier (110) through the electrical path (160).

14. A light emitting diode package structure (200), comprising:
a carrier (210), having a cavity (C2), a first pin (212) and a second pin (214);
a light emitting diode chip (220), disposed on the carrier (210) and located in the cavity (C2);
a first molding compound (230), disposed in the cavity (C2) and overlaying the light emitting diode chip (220), wherein the first molding compound (230) is mixed up with a fluorescent material (232);
a second molding compound(240), disposed in the cavity(C2) and overlaying the first molding compound (230); and
a package casing (250), enclosing the carrier (210) and exposing the first pin (212) and the second pin (214).

15. The light emitting diode package structure (200) as claimed in claim 14, wherein the carrier (210) comprises a lead frame.

16. The light emitting diode package structure (200) as claimed in claim 14, wherein the materials of the first molding compound (230) and the second molding compound (240) comprise methyl-series silicone adhesive, ethylic-series silicone adhesive or cyclobenzene-series silicone adhesive.
